# EUROPEAN PATENT APPLICATION

(11) **EP 0 539 109 A1**
(43) Date of publication of application: **28.04.1993**
(21) Application number: 92309449.4
(22) Date of filing: 16.10.1992
(51) Int. Cl.: B29C 45/27

(54) **Transfer mold having balanced runners**

(30) Priority: 24.10.1991 US 782042
(71) Applicant: AT&T Corp., New York, NY 10013-2412 (US)
(72) Inventor: Zimmerman, Michael A., North Andover, Massachusetts 01845 (US)
(74) Representative: Johnston, Kenneth Graham

(57) **Abstract**

The present invention is directed toward a multicavity mold which provides a more balanced fill profile by equalizing the viscosity of the material which enters each cavity. The result is a reduced number of rejects caused by the molding process, and a finished product which can withstand relatively high temperature, is rugged in nature, and is compatible with modern high-speed pick and place technologies.

The development of molding compounds which exhibit low thermal coefficients of expansion and high fracture toughness has enabled transfer molding to be used in high volume production to package silicon integrated circuits. In this invention substantially identical conditions are established in each individual mold cavity of a plurality of mold cavities which are filled simultaneously during the molding process by providing runners which equalize the viscosity of the material flowing into each cavity.

## Description

### Technical Field

This invention relates to molds for encapsulating an integrated semiconductor device coupled to a leadframe by the transfer molding process and more particularly to an improved runner design for a multicavity mold which equalizes the viscosity of the molding compound flowing into each mold cavity.

### Background of the Invention

Currently, plastic molding compounds are used to encapsulate a very large percentage of the multitude of silicon-integrated devices packaged throughout the world each year. The concept of encapsulating one or more silicon devices within a plastic package has contributed materially to reducing the cost of packaging devices. This, in turn, has led to the use of silicon devices in a wide array of products.

The development of molding compounds which exhibit low thermal coefficients of expansion and high fracture toughness has enabled transfer molding to be used in high volume production to package or encapsulate silicon integrated devices. The transfer molding process can be thought of as being comprised of the three distinct phases of A) filling a multicavity mold with molding compound, B) packing the molding compound in the mold, and C) curing the molding compound.

Presently, extreme care is required to prevent damage to wire bonds on the silicon devices and to the associated lead frame during the encapsulation process.

A study of the prior art process of encapsulating silicon integrated devices revealed that the molding process generated flow-induced device damage and pressure induced stresses on the silicon device, the leadframe and the connecting bands. The result is a poor yield.

This invention is directed toward increasing the yield of encapsulated silicon integrated devices.

### Summary of the Invention

The present invention is directed toward a multicavity mold which provides a more balanced fill profile by equalizing the viscosity of the material which enters each cavity. The result is a reduced number of rejects caused by the molding process, and a finished product which can withstand relatively high temperature, is rugged in nature, and is compatible with modem high-speed pick and place technologies.

The development of molding compounds which exhibit low thermal coefficients of expansion and high fracture toughness has enabled transfer molding to be used in high volume production to package silicon integrated circuits. In this invention substantially identical conditions are established in each individual mold cavity of a plurality of mold cavities which are filled simultaneously during the molding process by providing runners which equalize the viscosity of the material flowing into each cavity.

### Brief Description of the Drawing

In the drawing forming a part of this application and in which like parts are designated by like reference numerals throughout the same:
Fig. 1 illustrates a cutaway view of a semiconductor device electrically coupled to leads of a leadframe and encapsulated in plastic;
Fig. 2 illustrates a typical leadframe;
Fig. 3 illustrates molding material advancing in a mold cavity during the encapsulating process;
Fig. 4 illustrates viscosity for common molding compounds as a function of shear rate, temperature and time;
Fig. 5 is a view of a prior art transfer mold top plate assembly illustrating eight molding cavities and the runner configuration for directing molding compound to the eight mold cavities;
Fig. 6 illustrates a defective bowed lead frame which was bowed while being encapsulated by a prior art transfer mold assembly;
Fig. 7 is a plot of a typical prior art process versus time curve used to avoid the bowing problem;
Fig. 8 illustrates the uneven flow of material into eight adjacent mold cavities of a prior art transfer plate mold;
Fig. 9 illustrates temperature contours of molding material in adjacent cavities of a prior art transfer plate mold at 60% fill;
Fig. 10 illustrates a new improved runner system in accordance with the principles of the invention;
Fig. 11 illustrates the flow of material into eight adjacent mold cavities of a transfer plate mold having the new improved runner system in accordance with the principles of the invention;
Fig. 12 is a plot of a typical pressure versus time profile for a transfer plate mold having a new improved runner system in accordance with the principles of the invention; and
Fig. 13 illustrates temperature profiles of molding compound in eight adjacent cavities of a transfer plate mold having the new improved runner in accordance with the principles of the invention.

### Detailed Description

Silicon integrated devices, because of their small size and fragile nature are frequently embedded in a plastic molding compound and electrically connected to an array of electrical conductors which project beyond the edge of the assemblage. The ends of the electrical conductors embedded within the plastic molding compound and located close to the silicon device are known as the inner leads and are connected to bonding pads on the silicon device through fine wire bonds. The outer ends of the leads which project outward from the edge of the assemblage are shaped to form "J" type leads or "gull wing" leads for mounting onto a circuit board.

The plurality of leads which connect the silicon device to the circuit board is stamped or punched from sheet material and is called a leadframe . In those instances where the density of the leads is high, the leads may be formed by etching because the spacing between the inner leads may be too small to be formed with a punch tool.

After the leadframe is formed, the inner end of each lead is connected to a bond pad on a silica device by means of a gold or aluminum wire. In some instances, the silicon devices are supported by a ceramic member which, in turn, is physically supported by the inner leads. Thus, the ends of the inner leads are electrically connected to the silicon device and also provides support for the silicon device.

One method of forming the final package is by a "post-molding" process. In the process the leadframe and the attached silicon integrated device is encapsulated by a thermoset plastic molding compound.

Encapsulation normally occurs in a production-size molding tool over a three minute cycle. Of the three minute cycle time, the plastic molding compound flows into the mold in about 15 seconds, two minutes is needed to polymerize or cure the plastic; and the remaining time is used to prepare the mold for the next molding cycle, The plastic molding compound generates flow-induced stresses on the fragile silicon device, the connecting wires and the leads as it fills the cavity. This flow-induced stress causes damage and yield loss.

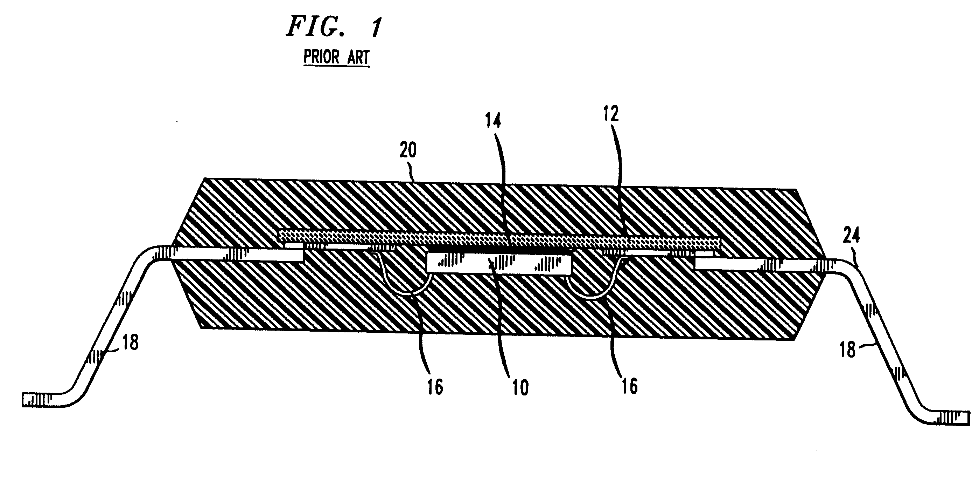

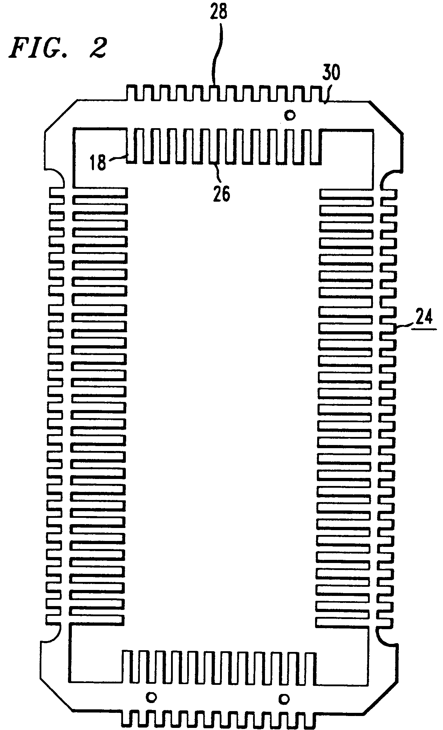

Referring to Fig. 1, there is illustrated a cutaway view of a semiconductor device supported by a ceramic member and electrically coupled to the leads of a leadframe and encapsulated in plastic. In the illustrated embodiment, a silicon device 10 is secured to a ceramic member 12 by thermally conductive epoxy adhesive 14. The ceramic member 12 supports conductive paths for making electrical connections from the silicon device to the leads of a lead frame 24. Fig. 2 illustrates a typical leadframe 24. Returning to Fig. 1, fine wire bonds 16 electrically connect the various bond pads on the silicon device 10 to appropriate conductive paths on the ceramic member 12. The conductive paths on the ceramic member 12 are also connected electrically to the inner ends of the various leads 18 of the leadframe 24. In the completed assemblage, the ceramic member 12, silicon device 10, wire bonds 16 and inner ends of the leads 18 are embedded within plastic molding compound 20 which provides support and electrical isolation.

The lead 18 for surface mount packages are normally formed into "J" leads or "gull wing" leads. J leads extend under the molded body and conserve area on the circuit board. However, they are difficult to inspect. Gull wing leads, such as leads 18 are formed to extend away from the molded body and allow for visual inspection of solder attachments to a printed circuit board. Fine pitch plastic packages typically use gull wing lead when attachment yield is an issue.

Referring now to Fig. 2, there is illustrated a typical lead frame prior to being attached via soldering to the ceramic member 12. The leadframe 24 can be of a flat sheet of metal such as copper, copper alloy or the like stamped or etched to form a square on a rectangle of a plurality of conductive leads 18 having inner ends 26 and outer ends 28. The outer ends 28 are attached to an outer frame support member 30 which holds the various leads 18 in position relative to each other until after the ends 26 of the leads 18 have been connected to the ceramic member 12 and the wire bands 16, and the assemblage has been encapsulated in the plastic molding compound. Following the molding process the outer frame support member 30 is removed from the leads 18; and, the ends 28 of the leads 18 are formed to the final configuration in a trim and form operation.

Briefly, there are several different organic and inorganic materials used to package silicon devices commonly referred to as microelectronic devices. They include copper-rich alloys and an iron-nickel alloy. Iron-nickel has a coefficient of thermal expansion which is closer to silicon and has better mechanical properties than the copper-based alloys. The disadvantage of iron-nickel is that it has a low thermal conductivity. The ever increasing need to dissipate heat as the devices become larger requires using copper alloys, it being remembered, however, that these materials have limitations on thermal expansion and mechanical properties.

The metal leads 18 have a direct effect on the performance characteristics of the device as they provide a path for removing heat from the silicon device. The leads are formed from punched or stamped sheet stock. Those which require high interconnection density, such as 164-lead packages and above, are normally formed by etching because the inner lead spacing is too small to be formed with a punching tool. Gold or aluminum wires 12 are used to connect the ends 26 of the leads to the band pads on the silicon device.

The encapsulating material, which is a thermoset polymer molding compound, is one of the most important materials in molded plastic packaging. The molding polymer is converted from a low-viscosity fluid to a hard plastic during the process. Although it has a softening point, or glass transition temperature, it does not flow after polymerization, even at soldering temperatures, because it has a cross-linked molecular architecture.

Epoxy is the cross-linkable resin for nearly all commercial molding compounds. The formulation consists of a mixture of epoxy resin, hardener, catalyst, fillers, flame retardants, flexiblizers, coupling agents, mold release agents and colorants. Important molding compound properties include low viscosity to reduce damage to the fragile assemblies during molding, rapid cure to provide high productivity and low thermal shrinkage forces caused by differences in coefficient of thermal expansion among molding compound, leadframe and the silicon device.

Present day low-stress molding compounds have low coefficient of thermal expansion and low modulus to minimize the stresses generated, excellent strength to resist the cracking these stresses promote, and good adhesion to the silicon device and leadframe to disseminate the stresses over the entire package volume. Normally, the molding compound contains about 75 percent by weight of inorganic filler, e.g., ground silicon to lower the coefficient of thermal expansion and increase thermal conductivity. Higher filler loadings achieved trough improvements in filler size and size distribution have lowered the coefficient of thermal expansion while reducing the material viscosity.

Almost all post-molded plastic packages are made by the transfer molding process using thermoset molding compounds. In this process, an assembled leadframe is loaded on the molding tool either manually or with an automated leadframe loader and the molding tool is then placed in an oven where it is preheated. The molding compound is pre-softened by heating it in a dielectric preheater above its glass transition temperature. It is then placed in a cylindrical cavity in the molding tool. The operator starts the transfer by beginning the plunger movement that pushes the molding compound out of the transfer pot and into either the top or bottom portion of the preheated mold cavity. After the mold is filled, the pressure is increased to pack and further polymerized the molding compound under a higher applied pressure. Packing is important because the material is porous after filling. Packing compresses both macroscopic and microscopic voids in the molded body and lowers package permeability to eliminate voids where water can collect and promote corrosion. After the molding process, the leads are formed.

The flow of the molding material and its subsequent properties after molding are a function of the process profile, i.e., pressure, temperature, velocity, time; the deformation and flow characteristics of the molding material, and the features and geometrics of the mold.

The transfer molding process can be considered to be comprised of three distinct phases identified as filling, packing, and curing. The types of defects which commonly occur during molding include incomplete fills, voids - air bubbles from incomplete venting; blisters - air bubbles remaining at the surface; pinholes - voids which are open at the surface; and various forms of internal device damage.

The last noted category can include one or more of the following: A) Wire sweep which is caused by flow-induced stress due to viscous drag and surface tension effects; B) Leadframe and/or wire damage due to excessive molding pressure or material forces in individual cavities of a multicavity mold; and C) Molding compound pressure imbalance above and below the leadframe causing excessive bending and tensile stresses in the wires and other components.

The extent to which the above noted defects occurs is dependent on the many interrelated design and process variables which include pressures, temperatures, flow rates and flow directions, along with material rheology including its time and temperature viscosity dependent characteristics and its rate of reaction. In addition, during the filling cycle, the viscosity of the material increases to a factor of six or seven times and, therefore, the mold-design must define the flow so that the material achieves certain characteristics during the encapsulation process.

Flow-induced device damage and pressure-induced stresses, each of which depend on kinematics and the material properties at the instant of contact are major contributors to lowering yield. Normally, velocities of the encapsulating material are typically low enough not to cause these forces to be too high. But, the viscosity of the molding compound can increase substantially as a result of low temperature or high conversion thus causing high forces.

To minimize component damage, it is necessary to minimize material viscosity, pressure, and velocity, and to optimize flow front and streamline orientation during molding. Competing with these criteria are appropriate ranges of parameters to minimize other defects such as voids and process ranges to optimize the performance of the epoxy resin. All this must be done, not for one, but for each cavity in a production mold to produce parts having equal properties.

The first step in the molding of a thermoset is to heat both the mold assemblage and the material. The material is heated to its softening point, normally with a dielectric heater. The softening temperature is near 90 ° C for epoxy resins. The preheated molding material is then put into the transfer pot, and upon activation of the transfer cycle, a plunger moves downward and delivers the material through runners in the upper platen to the mold cavity. The material enters the mold and then travels through the runner system in a way that distributes the material to all of the cavities of the mold. The material enters each mold cavity through a narrow opening called a gate and air escapes from the mold cavities through small vents.

Thermoset molding is characterized by the fact that the mold is heated to a temperature which is much higher than the temperature of the incoming material. Thus, the temperature of the molding material rises as it flows through the runner system. The amount of heat transferred to the molding compound, and thus the temperature of the molding compound is dominated by conduction and frictional heating of the molding compound as it advances along the runners of the mold, Thus, as the molding material traveling through the runners, its temperature increases and thus its viscosity is changed.

As a function of time, the viscosity of the heated material goes through a minimum and begins to increase as the material cures. The precise viscosity vs. time curve depends principally on the temperature and shear rate of the material.

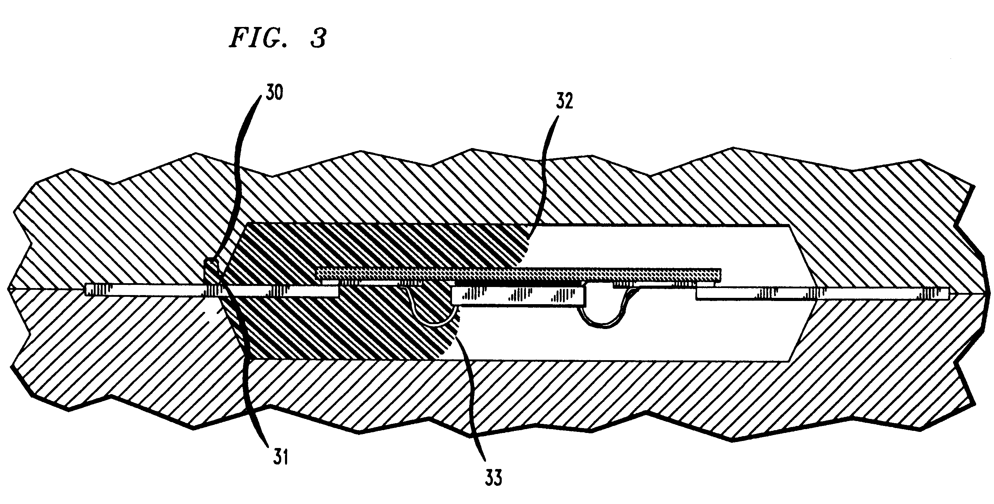

Referring to Fig. 3, based on gate design, leadframe design, and the cavity dimensions above and below the leadframe, normally the molding material enters the cavity from a runner 30 and gate 31 located above the leadframe, splits into two parts, a top part 32 being above the leadframe and a lower part 33 being below the leadframe. Each part advances simultaneously above and below the leadframe as is illustrated in Fig. 3. The fronts of each part advance at different rates based on cavity thicknesses and process conditions. The location where the flow fronts meet is called a weld or nit line. The weld line is an area of local weakness and can act as a stress concentration. The properties of the weld line will be proportional to the pressures and temperatures of the converging flow fronts.

Epoxy novolac resins are the materials widely used for packaging microelectronic devices. The material is highly filled in order to lower its coefficient of expansion to be compatible with leadframe materials and other components to be encapsulated. The formulation of the material can include, in various amounts, the following ingredients: Epoxy novolac, Phenal novolac, catalyst, low stress additive, Releasing agent, Filler, and Black carbon.

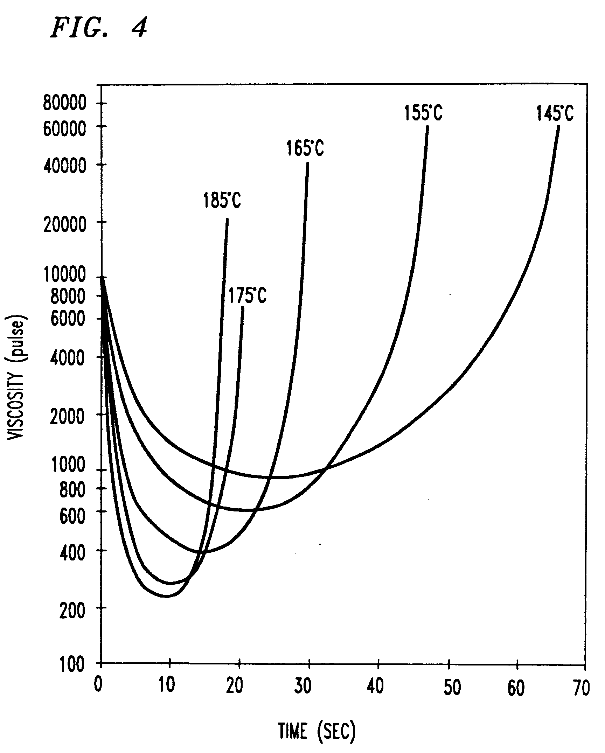

The epoxies used in transfer molding are extremely complex in nature. In a liquid state, epoxies are non-Newtonian time-dependent fluids, where the shear rate is proportional to the magnitude and duration of shear stress. The material is thixotropic and exhibits a reversible decrease in shear stress with time at a constant shear rate and temperature. Also, upon decrease of shear rate in a continuous process a hysteresis occurs where shear stress does not follow the same path. Fig. 4 shows viscosity data for common molding compounds as a function of shear rate, temperature, and time.

There has been a great deal of work in developing constitutive models for time dependent (pseudoplastic) fluids which don't exhibit a yield stress. These materials are characterized by linearity at very low and very high shear rates.

From short-shot analysis (where filling is stopped at predetermined intervals of time), it is quite clear that as the material is highly filled, it does not behave as a free liquid until the liquid-solid system experiences a certain threshold of pressure. Pressurization was observed to occur when the runner system is filled and back pressure is generated as the material passes through the narrow gates.

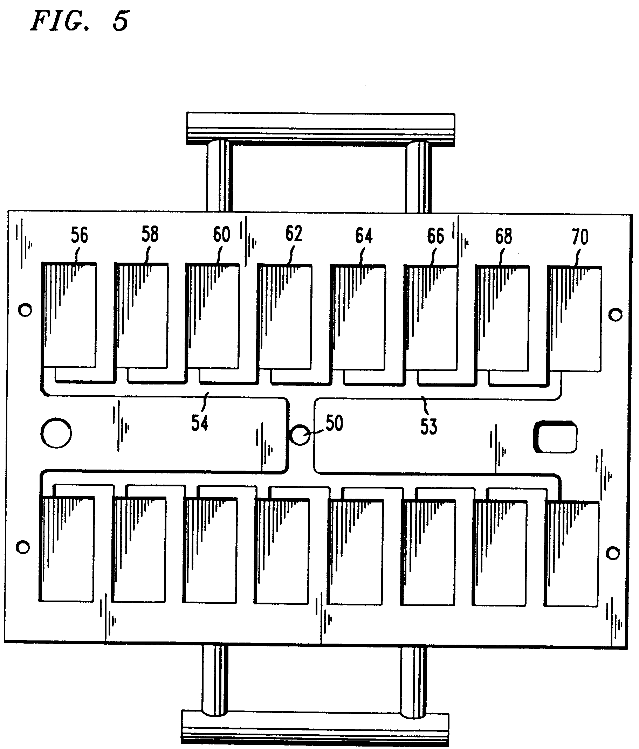

Referring to Fig. 5, there is a view of a prior art top plate mold assembly illustrating the runners and mold cavities. The runner system is the standard H configuration where the material coming from the pot travels to port 50 of runner 52, then along runners 53 and 54 to fill the eight cavities 56, 58, 60, 62, 64, 66, 68, 70. The runners are filled from port 50 of runner 52 outward.

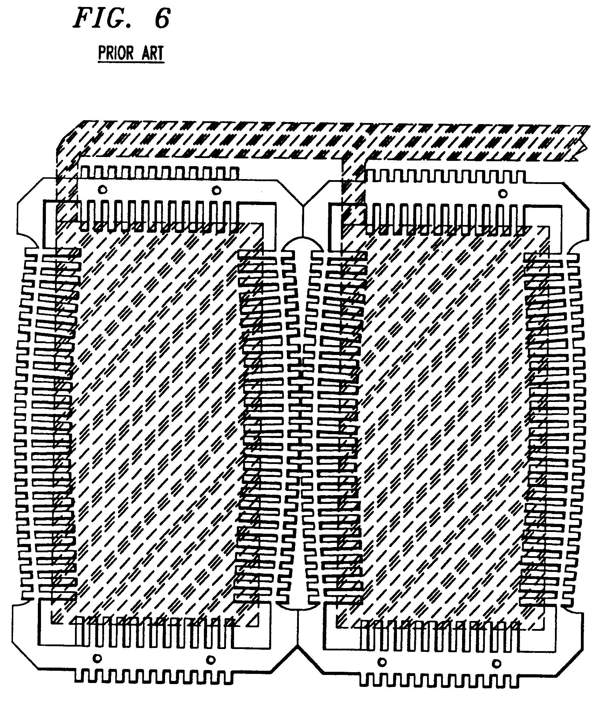

Prior art mold designs are extremely sensitive to process parameters. Under various sets of conditions, leadframes were bowed by the filling material, wire bonds were damaged, and the process window employed to minimize this effect was very small. Fig. 6 shows a typical part with a bowed leadframe where standard and recommended process parameters were used.

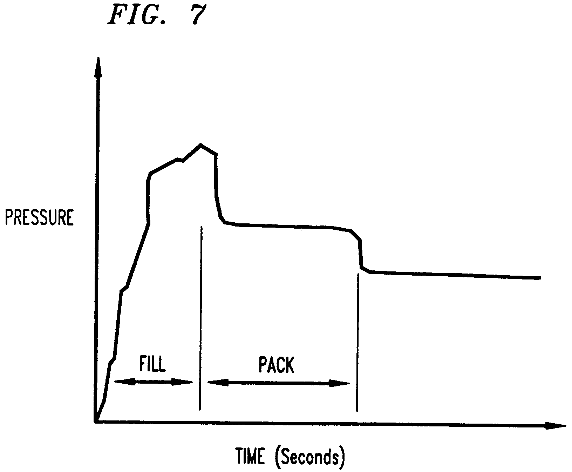

Fig. 7 illustrates typical prior art hydraulic pressure Vs. time curve used to correct the bowing problem. The packing pressure is ramped down immediately after 100-percent fill to a low level. This reduction of pressure allows the parts to be filled and minimally packed for use as engineering models, but dots not provide for optimum processing conditions to maximize yield and reliability.

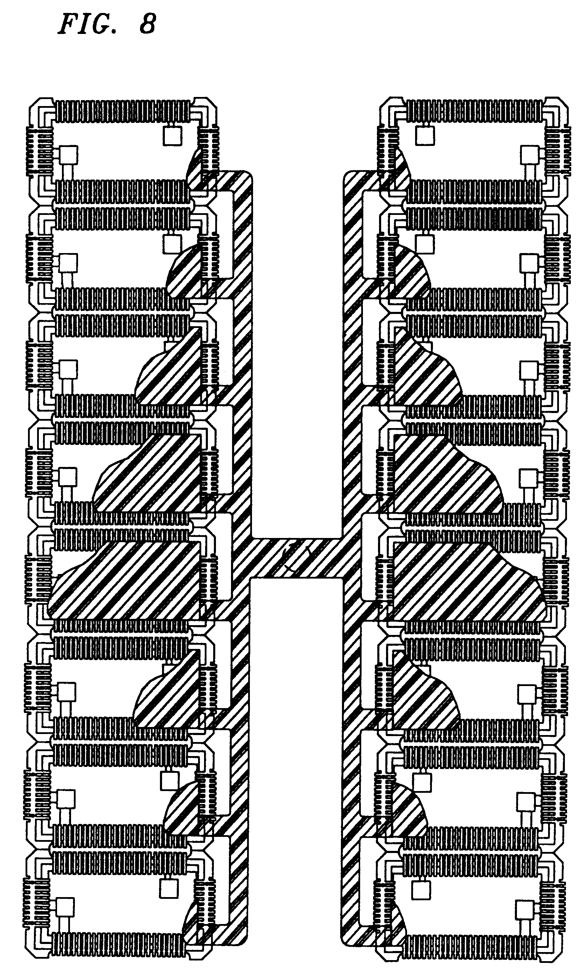

An analysis of the filling of the mold was done by a series of of short-shot experiments. Fig. 8 shows one increment of the filling profile. The material enters and substantially fills the center cavities first. Thereafter, the outside cavities begin to fill. Later on, the inside cavities slow in fill velocity as the outside cavities actually speed up and pass the inside cavities.

This analysis suggests several factors which may contribute to the bowing effects. It's quite clear that material is racing into the center cavities, and as the material has not had an opportunity to gain much heat from the runners, it is still fairly cool and, therefore, has a relatively high viscosity. This causes higher than necessary viscous forces. Also, as the fill is unbalanced amongst the eight cavities, the flow rates and velocities are extremely high in the center cavities.

In the final portion of fill, the material in the center cavities appears to slow in velocity and may even hesitate. The flow from the pot is then directed towards the outside cavities, where the flow fronts pass the flow fronts in the inner cavities. This transient effect is really an equilibrium condition where the material tends to flow in the direction of the least resistance.

This hesitation effect can be very severe in the late stages of the filling profile. As the material hesitates, the heat flux through the mold wall causes the epoxy's temperature to rise quickly, and skin layers occur at a very rapid rate. The overall effect is that the viscosity of the material can increase very sharply, and cause high forces during packing.

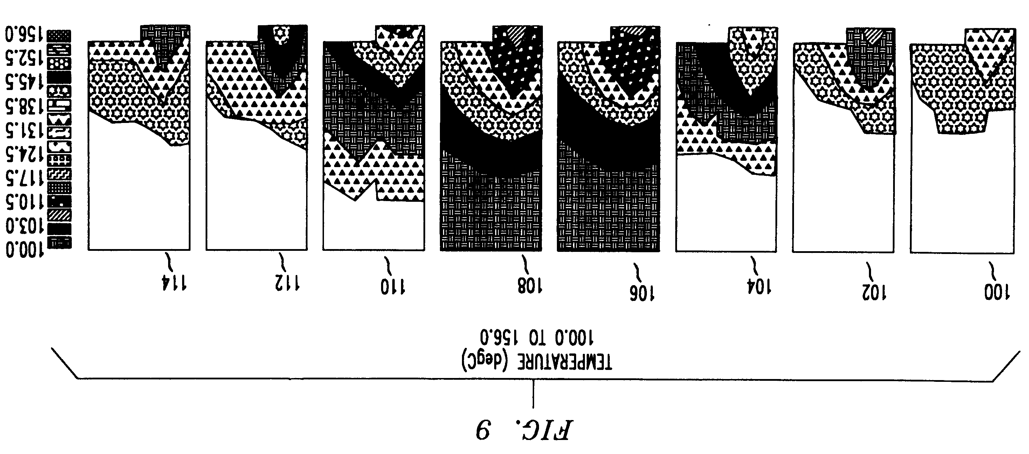

Referring to Fig. 9, there is illustrated temperature contours at 60-percent fill. The material enters the platen of the mold at 100 ° C and reaches 104.4 ° when it exits the feed runner. The molding compound reached the following temperatures immediately prior to entering each gate of the eight mold cavities aligned along one side of the mold where gates for mold cavities 100, 102, 104, 106, are for the mold cavities on the left, the gate for mold cavity 106 being close to the center and the gate for mold cavity 100 being at the end of the mold plate; and, gates for mold cavities 108, 110, 112, 114 are for the mold cavities on the right branch, the gate for mold cavity 108 being part of a center mold cavity and the gate for mold cavity 114 being part of an end mold cavity:
Gate for mold cavity 100 = 105.9°C
Gate for mold cavity 102 - 110.5°C
Gate for mold cavity 104 = 116.7°C
Gate for mold cavity 106 = 126°C
Gate for mold cavity 107 = 107.6°C
Gate for mold cavity 110 = 112.6°C
Gate for mold cavity 112 = 119.7°C
Gate for mold cavity 114 = 130.2°C
The difference in temperature of the molding compound at the gates for mold cavities 100 and 106 is 20°C, while the difference in temperature of the molding compound at the gates for mold cavities 108 and 114 is 26°C. Clearly, this temperature difference can cause a substantial difference in the viscosity of the material at the vinous gates and can be the cause of an imbalance which contributes to the large difference in filling profiles between the inside and outside cavities.

Since the material is a thermoset, its properties at the completion of the molding process are affected by its time and temperature histories. In this case, it can be observed that there is a large temperature and time difference between fill profiles between the inside and outside cavities. This causes the properties of the packages being molded in the inside and outside cavities to be different.

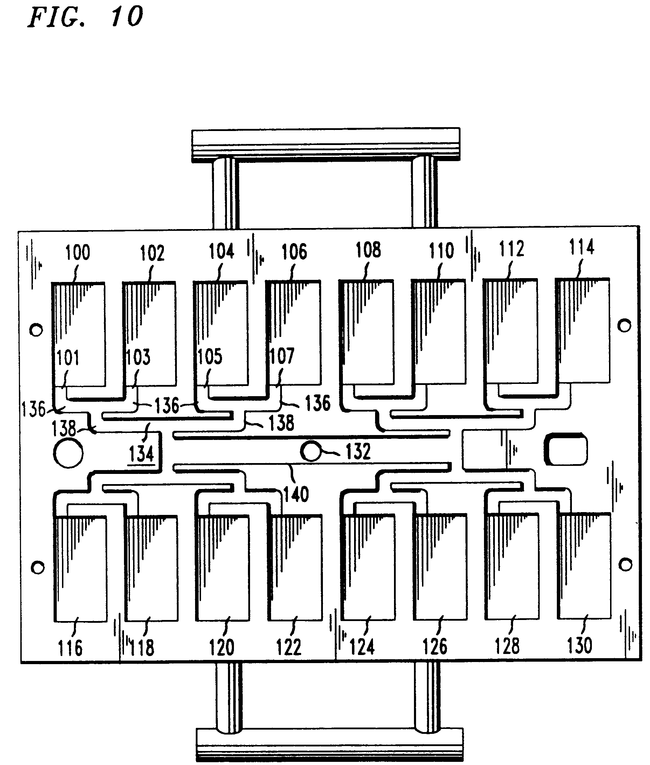

Fig. 10 illustrates a runner system in accordance with the principles of the invention for balancing the temperature of molding material flowing into the eight mold cavities along one side of a transfer mold. Along with pressure and geometry balancing, a longer runner length provides for more heat transfer into the molding material which enters each gate. This results not only in lower viscosity, but a more uniform viscosity of the molding material flowing into each mold cavity.

Referring to Fig. 10, there is illustrated a view of a top plate of a transfer mold die having sixteen mold cavities 100-130. The transfer die mold can be considered to be comprised of four sections, each comprised of four similar size mold cavities. Section one includes mold cavities 100-106; section two includes mold cavities 108-114; section three includes mold cavities 116-122; and, section four includes mold cavities 124-130. Referring to the section one which consists of mold cavities 100-106; each mold cavity 100-106 is connected, via similar sized gates 101-107 and a balanced runner array 134, to a molding compound entry port 132.

The balanced runner array 134 comprises a plurality of runners which extend from entry port 132 to each gate 101 - 107 where each runner is sized to deliver to each gate 101-107 of each die cavity 100-106 molding compound having substantially similar temperatures. One such arrangement is illustrated in Fig. 10 where the distances between the molding compound entry port 132 and the gates 101-107 of the die cavities 100-106 are substantially equal. The die cavities of the other sections are coupled to receive molding compound from entry port 132 via a similar runner array. The various arms 136, 138 and 140 of the runner array art sized to prevent the occurrence of molding compound starvation in any arm.

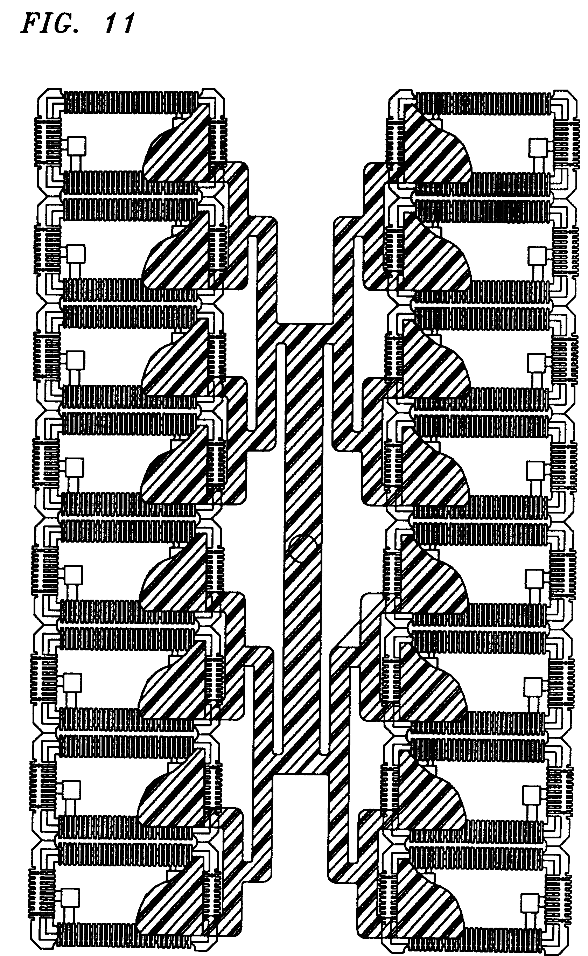

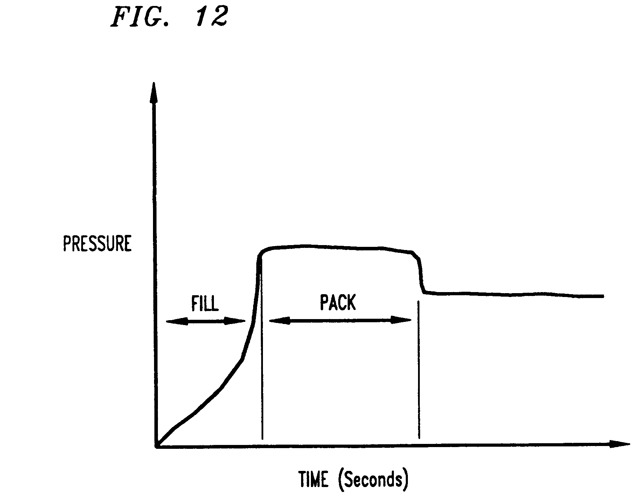

Referring to Fig. 11 there is illustrated the flow of molding compound into eight mold cavities using the new improved runner system here disclosed. Fig. 12 illustrates a typical pressure versus time profile for the new improved runner here disclosed. Clearly, the fill profile is more desirable. The resulting parts reflected much better packing and eliminated the bowing problem.

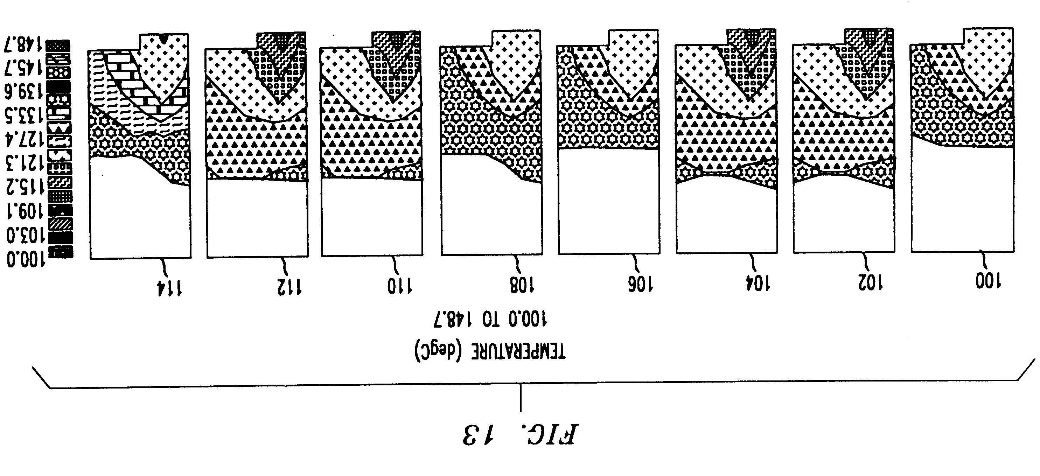

The temperature profile is quite telling. Fig. 13 shows temperature profiles at 60-percent fill. Here, the temperatures of the material immediately before entering each gate is now as follows:
Gate for mold cavity 100 = 119.6°C
Gate for mold cavity 102 = 111.8°C
Gate for mold cavity 104 = 111.8°C
Gate for mold cavity 106 = 119.6°C
Gate for mold cavity 108 = 120.8°C
Gate for mold cavity 110 = 113.0°C
Gate for mold cavity 112 = 113.0°C
Gate for mold cavity 114 = 120.8°C
The maximum difference in molding compound temperatures is 8.1 °C, which is half of what it was in the prior art mold. This smaller temperature differential is a key factor in equalizing the viscosity of the material in each cavity and providing for a mort balanced fill profile.

What has been described is merely illustrative of the application of the principles of the present invention. Other arrangements and methods can be implemented by those skilled in the art without departing from the spirit and scope of the present invention.

## Claims

1. A transfer mold comprising
means defining a plurality of mold cavities,
a plurality of gate means each associated with, and coupled to a respective one of said mold cavities for admitting molding compound into said mold cavities,
a feed port for receiving heated molding compound, and
means defining a plurality of runners to direct said molding compound from said feed port to each of said gate means, the distance along said runners from said feed port to each of said gate means being substantially the same.

2. The transfer mold as defined in claim 1 wherein each of said runners from said feed port to said gate means traces a discrete path.

3. The transfer mold as defined in claim 2 wherein at least a part of two of said runners share a common path.

4. The transfer mold for as defined in claim 3 wherein said common path is less than the length of either runner from said gate means to said feed port.

5. The transfer mold as defined in claim 2 wherein said
means defining a plurality of mold cavities comprises at least four mold cavities.
said means defining a plurality of runners comprises first, second, third, fourth, fifth, sixth and seventh runners,
said first runner is coupled to direct molding compound from said feed port toward each of said gate means,
said second runner is coupled to direct molding compound from said first runner toward said first and second gate means,
said third and fourth runners are coupled to direct molding compound from said second runner to said first and said second gate means of said first and second mold cavities respectively,
said fifth runner is coupled to direct molding compound from said first runner toward said sixth and seventh gate means, and
said sixth and seventh runners are coupled to direct molding compound from said fifth runner to said third and said fourth gate means of said third and fourth mold cavities respectively.

6. The transfer mold as defined in claim 4 wherein said gate means to each of said mold cavities are substantially similar in size.

7. A transfer mold for encapsulating a semiconductor device within molding compound comprising
a first plate member having a first plurality of depressed areas to provide top cavity molds,
a second plate member having a second plurality of depressed areas to provide bottom cavity molds,
said first and second plate members being adapted to align said first plurality of depressed areas with said second plurality of depressed areas to form a plurality of mold cavities, each mold cavity being adapted to support a semiconductor device electrically connected to selected conductors of a leadframe,
gate means coupled to each of said mold cavities and supported by said first plate member for admitting molding compound to said mold cavities,
a feed port supported by said first plate member for receiving heated molding compound,
runners in said first plate member adapted to direct molding compound from said feed port to each of the gate means, and
said runners for each mold cavity being sized to deliver molding compound of substantially similar temperature to each gate means of each cavity.

8. A method of encapsulating at least three devices simultaneously in a mold having at least three mold cavities comprising the steps of
placing a device which is to be encapsulated within each of said at least three mold cavity,
heating said mold, and
providing molding compound of substantially similar temperature to each of said molds.

9. The method of claim 8 further comprising the step of filling each of said mold cavities substantially simultaneously.

10. A transfer mold comprising
means defining a plurality of mold cavities,
a plurality of gate means each associated with, and coupled to, a respective one of said mold cavities for admitting molding compound into said mold cavities,
a feed port for receiving heated molding compound, and
means defining a plurality of runners coupling said feed port to said gate means to direct said molding compound of substantially the same temperature to each of said mold cavities.
